# FASCICULE DE BREVET EUROPEEN

(11) **EP 2 148 747 B1**
(45) Date de publication et mention de la délivrance du brevet: **28.11.2018**
(21) Numéro de dépôt: 08805859.9
(22) Date de dépôt: 27.05.2008
(51) Int. Cl.: B05D 7/00, H01L 51/00, H01L 51/42, B05D 1/18

(54) **COUCHES MINCES DE POLYMÈRES CONJUGUÉS CONTENANT DES NANOPARTICULES INORGANIQUES ET LEUR PROCÉDÉ DE FABRICATION**
DÜNNSCHICHTEN AUS KONJUGIERTEN POLYMEREN MIT ANORGANISCHEN NANOPARTIKELN UND HERSTELLUNGSVERFAHREN DAFÜR
THIN FILMS OF CONJUGATED POLYMERS CONTAINING INORGANIC NANOPARTICLES AND MANUFACTURING PROCESS THEREOF

(30) Priorité: 28.05.2007 FR 0755289
(43) Date de publication de la demande: 03.02.2010
(73) Titulaire: Commissariat à l'Énergie Atomique et aux Énergies Alternatives, 75015 Paris (FR); Centre National de la Recherche Scientifique, 75794 Paris (FR)
(72) Inventeur: REISS, Peter, F-38120 Saint Egreve (FR); DE GIROLAMO, Julia, F-38700 La Tronche (FR)
(74) Mandataire: Cabinet Plasseraud
(86) Numéro de dépôt international: PCT/FR2008/050915
(87) Numéro de publication internationale: WO 2008/152295

(56) Documents cités:
- US-A1- 2002 045 045
- US-A1- 2002 155 442
- US-A1- 2003 077 625
- US-A1- 2003 226 498

## Description

Un grand nombre d'applications à base de *nanoparticules inorganiques* découlent de leurs propriétés optiques, électroniques ou magnétiques qui dépendent de leurs tailles. Des exemples importants sont les nanocristaux fluorescents de semi-conducteurs (*e.g.* CdSe, CdTe, InP, ZnO), les nanoparticules d'or et les nanoparticules d'oxyde de fer ou d'alliage fer-platine.

En association avec des *polymères conjugués, les nanocristaux de semi-conducteurs* constituent des matériaux prometteurs pour la conversion lumière-électricité par effet photovoltaïque. Parmi d'autres applications émergeantes, on peut citer les diodes électroluminescentes.

Les *nanoparticules métalliques* (*e.g.* Au) sont utilisées *en combinaison avec des polymères conjugués* dans des mémoires moléculaires non volatiles, en électrocatalyse ou en tant que capteurs chimiques.

Les *nanoparticules magnétiques* sont envisagées comme « bits » de stockage d'information dans de futurs medias d'enregistrement magnétique ou en tant que constituants de nouveaux matériaux présentant un transport électronique dépendant du spin (domaine de la « spintronique »).

Une application émergeante des nanoparticules (NPs) et des nanocristaux (NCs) semi-conducteurs consiste à les incorporer dans des films de polymères conjugués dans le but d'obtenir de nouveaux matériaux pour le photovoltaïque. L'intérêt des NCs dans ces dispositifs est double puisqu'ils participent à l'absorption de la lumière solaire et assurent le transport des électrons.

Une première approche de la préparation des films consiste à faire croitre de manière *in situ* les NCs/NPs dans le polymère conjugué. Selon cette approche on fait directement croître les NCs ou NPs dans le polymère conjugué [*e.g.* NPs de Au dans le poly(hexylthiophene : J. Mater. Chem. 2004, 14, p. 141]. Bien que cette méthode assure une bonne dispersion des particules dans le polymère, elle ne permet généralement pas d'obtenir des NCs ou NPs ayant une faible dispersion en taille. Ceci est un inconvénient majeur car les propriétés physiques des NCs/NPs dépendent fortement de leur taille.

De plus, un nouveau procédé doit être développé pour chaque type de NCs ou NPs et la méthode ne permet pas d'optimiser indépendamment la synthèse des particules et du polymère.

Une autre stratégie consiste à mélanger les NCs ou NPs avec des polymères conjugués. C'est la méthode la plus utilisée pour la fabrication des dispositifs photovoltaïques à partir de NCs semi-conducteurs tels que le CdSe et de polymères conjugués, tels que le poly(3-hexylthiophène) ou le poly(p-phénylène-vinylène) [e.g. cellules solaires CdSe/PPV : J. Appl. Phys. 2005, 97, p. 014914, brevet EP1485955]. Cependant, il est difficile de contrôler la morphologie des couches minces obtenues à partir de ces mélanges, car une forte ségrégation de phase entraîne une diminution des performances des cellules solaires.

Une autre méthode consistant à greffer successivement des couches de nanocristaux de CdSe et des couches de polymère a récemment été proposée par [Wang et al., Adv. Funct. Mater., 2006, 16, p. 542]. Cette technique conduit à des films dans lesquels le polymère et les nanocristaux sont liés de manière covalente. Bien que cette méthode évite une démixtion des deux constituants, la forte liaison entre eux empêche l'optimisation de la structure de la couche mince obtenue i) par le processus d'auto-organisation lors du dépôt ; ii) par une procédure de recuit thermique après le dépôt. Le recuit thermique entraîne généralement une modification de la morphologie de la couche mince. Cette méthode est largement utilisée pour augmenter la performance de cellules solaires à base de polymères conjugués et en particulier pour les cellules à base de polymère conjugués et des nanocristaux de semi-conducteurs (EP1485955). Cependant les films obtenus peuvent présenter des défauts de morphologie qu'il est difficile de traiter par application de recuit du fait de l'existence de liaisons covalentes au sein du film.

Le document US 2003/077625 présente un procédé de fabrication de nanoparticules et de dispositifs comprenant des nanoparticules utilisés dans des composants électroniques ou pour le stockage d'information.

L'efficacité de films préparés par les méthodes connues est souvent limitée par la difficulté à contrôler la morphologie des films. Généralement ces matériaux sont obtenus par simple mélange des deux constituants, NCs et polymère conjugué, ce qui le plus souvent provoque un phénomène de ségrégation, il s'agit d'une démixtion, de phase donnant lieu à des zones riches en polymère et des zones riches en NCs. D'autre part la technique de dépôt à la tournette (spin-coating en anglais) couramment utilisée pour l'élaboration des films est coûteuse en termes de consommation de matière car elle implique la perte d'une grande fraction de produits au moment du dépôt.

D'autres méthodes de fabrication de film hybride organique-inorganique pour le revêtement non covalent d'un support sont décrites dans les documents US 2003/226498, US 2002/045045 et US 2002/155442.

En résumé, les méthodes de fabrication de couches minces contenant des NCs ou NPs dans un polymère conjugué utilisées à ce jour ne permettent pas une mise en oeuvre facile et économique tout en assurant le contrôle de la morphologie et de la composition du matériau obtenu.

L'invention concerne un procédé de revêtement non covalent d'un support par un film hybride organique-inorganique comportant les étapes de :
- dépôt d'un polymère organique conjugué comportant des groupes organiques de type X sur le support ;
- dépôt de nanoparticules comportant un ou plusieurs groupes organiques de type Y sur le support ;
les groupes de types X et Y étant susceptibles de développer des liaisons de type hydrogène entre eux, le polymère organique conjugué comportant des groupes organiques de type X étant le poly(3-hexylthiophène) fonctionnalisé par la fonction diaminopyrimidine.

Typiquement les étapes de dépôt sont répétées, généralement de manière alternative, jusqu'à obtenir l'épaisseur souhaitée pour le film. Le dépôt peut être effectué sur l'ensemble du support ou sur une partie de celui-ci seulement.

Au sens de la présente invention un film hybride organique-inorganique correspond à un film constitué d'espèce organiques et inorganiques et notamment à un film comportant des couches successives de nature alternée. Plus précisément il s'agira de films polymériques au sein desquels existent des couches de nanoparticules inorganiques, conceptuellement ce type de film présente une alternance entre les couches polymériques et les couches inorganiques.

Les films dont il est ici question sont généralement considérés comme des films optiquement minces, leur épaisseur est comprise entre les échelles nanométriques et micrométriques.

Le procédé est de type « non covalent » en ce que la cohésion du film et celle du film sur le support n'est pas assurée par des interactions de type covalentes. Ainsi, le procédé, ne donne pas lieu au développement de liaisons covalentes entre les différents constituants du film, *i.e.* le polymère et les nanoparticules, ni au développement de liaisons covalentes entre le support et les constituants du film au contact de sa surface.

Les groupes organiques de types X et Y correspondent à des groupes chimiques présentant une affinité l'un pour l'autre et notamment des groupes chimiques développant des liaisons hydrogènes les uns avec les autres. Ce type de liaison est une forme d'association entre un atome électronégatif et un atome d'hydrogène, lui-même lié à un second atome relativement électronégatif. Les deux atomes électronégatifs appartiennent habituellement, mais pas nécessairement, à la première rangée de la classification périodique des éléments, il s'agira notamment de N, O et F. Les atomes comportant des doublets libres, comme l'oxygène, l'azote ou encore les halogènes, ou des lacunes électroniques, comme le bore, peuvent facilement être investis dans ce type de liaison.

Ainsi X et Y correspondront typiquement à des groupes chimiques comportant des fonctions présentant des atomes électronégatifs, comme les fonctions carbonylées ou encore les imines, ou des hydrogènes tels que décrits plus haut, comme il en existe dans les fonctions alcool ou amine. L'homme du métier est à même de déterminer les groupes qu'il est susceptible d'employer dans le cadre de l'invention.

Typiquement X et Y formeront un couple présentant en leur sein, pour X la structure carbonée de formule (I) : 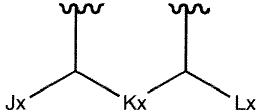 et pour Y la structure carbonée de formule (II) : 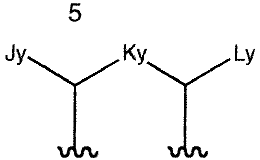 dans lesquelles
- des liaisons hydrogène sont susceptibles de se former dans au moins deux des couples Jx/Jy, Kx/Ky, Lx/Ly ;
- pour le couple Jx/Jy, un des J représente un N ou un O lié de manière covalente à un hydrogène et l'autre représente un N ou un O comportant une liaison de type π ;
- pour le couple Kx/Ky, un des K représente un atome d'azote lié de manière covalente à un hydrogène, et l'autre représente un N comportant une liaison de type π ;
- pour le couple Lx/Ly, les L représentent indépendamment des atomes d'hydrogène, de carbone, un N ou un O lié de manière covalente à un hydrogène, un N ou un O comportant une liaison de type π.

Les liaisons hydrogènes se forment de préférence dans les couples Jx/Jy et Kx/Ky. Avantageusement X et Y ont des structures cycliques, typiquement il s'agira de cycle à 5 ou 6 atomes.

X et Y peuvent ainsi par exemple correspondre au couple diaminopyrimidine/thymine. Il est ainsi par exemple sans faisant partie de la présente invention possible d'employer, à titre de groupes X et Y, des groupes identiques ou dérivés des bases présentes dans les chaînes nucléiques afin de mettre à profit leur complémentarité. Les bases puriques, adénine et guanine, et pyrimidiques, cytosine, thymine et uracile, ainsi que leurs dérivés, conservant bien entendu la structure assurant la formation de liaisons hydrogènes, sont utilisables dans le cadre de l'invention à titre de groupe X et Y. Il est bien sur préférable que l'adénine soit utilisée de manière complémentaire à la thymine ou à l'uracile, pour former deux liaisons hydrogène, et la guanine de manière complémentaire à la cytosine, pour former trois liaisons hydrogène. Le choix de couples connus pour leur complémentarité est recommandé, dans ces conditions la cohésion du film est meilleure.

Les polymères organiques conjugués correspondent à des structures polymériques de nature organique au sein desquelles existe une conjugaison. Ces polymères sont connus de l'art antérieur notamment pour leurs applications dans le domaine de l'électronique, on peut citer parmi eux les polymères aromatiques, hétérocycliques, linéaires ou polymères alternant hétérocycles et doubles liaisons, et notamment les poly(aniline)s, poly(alkylthiophène)s, poly(*p*-phénylène)s, poly(*p*-phénylène-vinylène)s, poly(fluorène)s, poly(pyrrole)s, poly(acétylène)s, amines polyaromatiques, poly(thienylène-vinylène)s et leurs dérivés solubles qui ne font pas partie de l'invention.

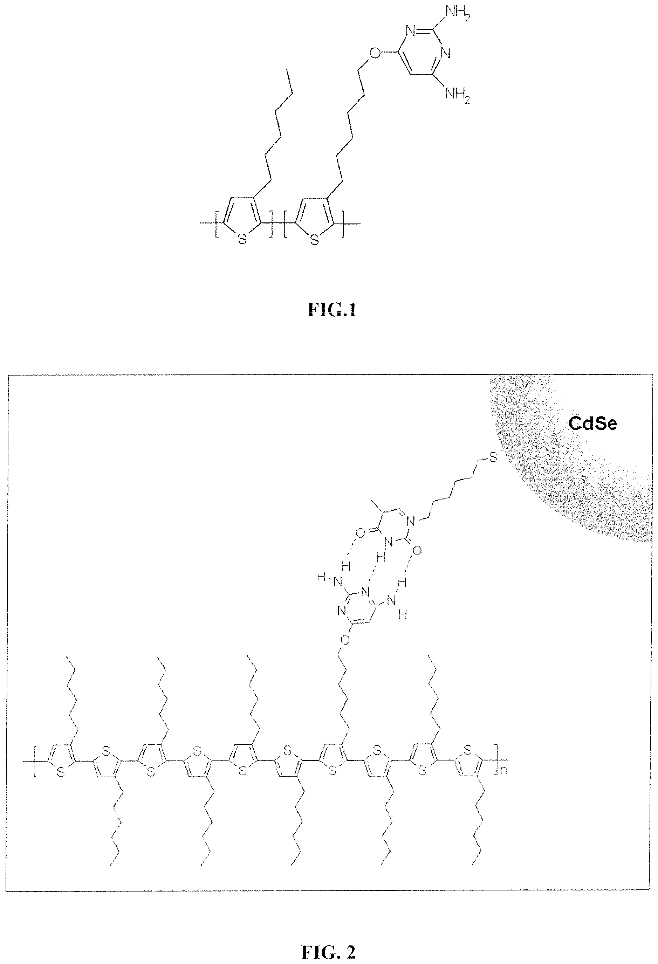

Selon l'invention il est souhaitable d'employer des polymères organiques conjugués comportant des groupes organiques de type X. Ces polymères sont généralement des copolymères dérivant d'un polymère conjugué tel que défini ci-dessus, présentant des unités monomériques modifiées qui comportent le groupe X. Typiquement le groupe X sera présent sur une chaîne latérale de telle sorte qu'il ne perturbe pas la conjugaison au sein du polymère, la quantité d'unité monomérique présentant une substitution par un groupe X sera généralement comprise entre 5 et 50%, et particulièrement entre 5 et 15%. Ainsi par exemple il est possible d'employer à titre de polymère comportant des groupes organiques de type X tel qu'un polymère de 3-hexylthiophène comportant, à hauteur de 10 à 15%, des unités monomérique portant un groupe organique de type X comme un 3-hexylthiophène lié à une 6-oxy-2,4-diaminopyrimidine à l'extrémité de la chaîne hexyle, ainsi que l'illustre la figure 1.

Il est préférable que les groupes X employés au sein du polymère soient de nature similaire et avantageusement qu'ils soient identiques. Les modalités de préparation des polymères sont connues en chimie organique, l'intégration du groupe X peut être facilement réalisée par dérivatisation d'une unité monomérique ainsi que l'illustre la partie expérimentale ou comme on peut le trouver dans la littérature, à ce titre il est utile de se référer à Mouffouk et al. CHEM. COMMUN. (2004) 2314.

Au sens de la présente invention une nanoparticule (NP) correspond à une particule inorganique de taille nanométrique, il peut notamment s'agir de nanocristaux (NC). Les NPs sont typiquement constituées d'au moins un métal et/ou d'au moins un composé semi-conducteur comprenant au moins un métal. Les métaux peuvent être notamment choisis parmi les métaux de transition, les terres rares, les métaux des groupes IIIA, IVA et VA du tableau périodique des éléments, leurs alliages, leurs oxydes et mélanges de ces métaux et alliages. Plus particulièrement l'invention s'applique à l'or, au platine, à l'argent, au cuivre, à l'oxyde de titane, l'oxyde de fer, aux alliages fer-platine, fer-palladium, et cobalt-platine.

S'agissant des semi-conducteurs il peut par exemple s'agir de composés de formule AB avec A un élément dont l'état d'oxydation est +II et B un élément dont l'état d'oxydation est -II, typiquement A est choisi parmi Mg, Ca, Sr, Ba, Zn, Cd, Hg, Sn, Pb et des mélanges de ces éléments, et B est choisi parmi O, S, Se, Te et des mélanges de ces éléments. Parmi les semi-conducteurs ont peut également citer les semi-conducteur de formule CD avec C étant un élément dont l'état d'oxydation est +III et D étant un élément dont l'état d'oxydation est -III, typiquement C est choisi parmi Al, Ga, In et des mélanges de ces éléments, et D est choisi parmi N, P, As, Sb, Bi et des mélanges de ces éléments. Les semi-conducteurs de formule ECB₂ avec E étant un élément dont l'état d'oxydation est +I, C étant un élément dont l'état d'oxydation est +III et B étant un élément dont l'état d'oxydation est -II, dans laquelle B et C sont choisis comme précédemment, E est choisi parmi Cu, Ag, Au, sont également concernés par l'invention. Enfin il est bien entendu possible d'employer des semi-conducteurs plus simples tels que le Si ou le Ge.

Les particules utilisées dans le domaine photovoltaïque ou dans celui des mémoires électroniques sont notamment concernées par l'invention, il s'agit particulièrement des particules de CdSe, CdTe, ZnO, PbSe, PbS, InP, InN, CulnS₂, CulnSe₂, Cu(In,Ga)Se₂, GaAs, InGaAs, Si, Ge, Au, Ag et Pt. Avantageusement pour des applications dans le domaine photovoltaïque il s'agira de NPs de CdSe, l'InP et le CulnSe₂, peut-être aussi Cu(In,Ga)Se₂ et CulnS₂ et dans le domaine des mémoires électroniques de Au, Ag et Pt.

Selon l'invention il est souhaitable d'employer des nanoparticules comportant des groupes organiques de type Y. De telles nanoparticules sont des entités hybrides organiques-inorganiques. Il s'agit notamment à d'une nanoparticule, ainsi que présentée plus haut, à laquelle est liée un ou plusieurs ligand organique comportant un groupe de type Y. Ainsi une nanoparticule de ce type présente typiquement un coeur inorganique, constitué d'au moins un métal et/ou d'au moins un composé semi-conducteur comprenant au moins un métal, auquel est lié au moins un ligand comportant un groupe organique de type Y qui constitue un enrobage, où couronne, de nature organique. Les ligands utilisables dans le cadre de l'invention sont notamment des ligands de formule (III) :

BG - (SG)ₚ - Y

Dans laquelle :
- BG représente un groupe de liaison susceptible de se lier à une nanoparticule de métal et/ou d'au moins un composé semi-conducteur comprenant au moins un métal ;
- SG représente un groupe espaceur ;
- Y est tel que défini précédemment ;
- p est égal à 0 ou 1.

Selon l'invention BG sera choisi en fonction du type de nanoparticule qui est employé dans le cadre du procédé. BG peut se lier de manière covalente, par complexation, chélation, ou par interaction électrostatique à la surface des nanoparticules. De manière utile, afin de déterminer la structure la mieux adaptée à la NP considérée l'homme du métier pourra notamment se référer à l'art antérieur et particulièrement à Colloids and Colloid Assemblies, Frank Caruso (Ed.), 1. Ed. Dec. 2003, Wiley-VCH, Weinheim.

BG peut notamment être un thiol, un dithiol, un carbodithioate, dithiocarbamate, xanthate, lorsque la particule correspond à un métal tel que l'or, l'argent, le cuivre, le platine, le palladium ou encore lorsqu'elle correspond à un semi-conducteur de type AB comme le CdSe, CdTe, ZnO, PbSe, PbS, CulnS₂, CulnSe₂ ou Cu(In,Ga)Se₂. Dans le cas des nanoparticules d'oxydes, tel que l'oxyde de titane, de zirconium, d'aluminium ou de fer, BG peut notamment correspondre à un acide carboxylique, acide dicarboxylique, acide phosphonique, acide diphosphonique, acide sulfonique, acide hydroxamique, les acides pouvant être sous forme déprotonée, ainsi que cela a été exposé dans l'art antérieur et notamment dans la demande de brevet WO2004097871.

Selon l'invention il est préférable que p soit égal à 1. Un groupe espaceur SG, correspond généralement à un groupe qui ne développe généralement pas d'interaction autre que de nature stérique ou d'affinité de type hydrophile ou hydrophobe avec le coeur inroganique de la nanoparticule, le polymère et le substrat, et qui ne réagit pas avec eux. Typiquement, l'espaceur peut être une chaîne carbonée ne comportant pas d'hétéroatome, il peut par exemple s'agir d'une chaîne de nature aliphatique, e.g. chaîne alkyl, de préférence de 1-12 atomes de carbone, d'une chaîne aromatique, ou d'une chaîne hétérocyclique.

Ainsi par exemple il est possible dans le cadre de l'invention d'utiliser notamment des NPs de CdSe fonctionnalisés avec 1-(6-mercaptohexylthymine). Un autre exemple correspond à des NPs d'or ou des NPs d'oxyde de fer, fonctionnalisés selon les procédés décrits dans les articles Nature 2000, 404, p. 746 et Chem. Mat. 2004, 16, p. 3252 avec des ligands contenant un groupe thymine. Il est également possible de d'utiliser des molécules type carbodithioate, dithiocarbamate ou xanthate contenant une fonction thymine pour la fonctionnalisation des nanocristaux de CdSe comme décrit dans la demande de brevet EP1548431.

Le support peut être de nature variable, considérant que l'invention permet de fournir notamment des dispositifs dans le domaine de l'électronique il est souhaitable d'appliquer le procédé à des supports constitués de matériaux employés dans ce domaine. Considérant que l'invention correspondant à un procédé de revêtement d'un support, seule la nature de la surface du support est susceptible d'interagir directement avec les constituants du film la recouvrant. Ainsi il peut notamment s'agir de supports présentant une surface de métal, d'alliages métalliques, ou de semi-conducteur. Plus particulièrement il est recommandé de choisir des supports à la surface desquelles il existe des oxydes, pour permettre notamment la formation de liaisons hydrogène entre la surface du support et le polymère ou les nanoparticules à sa proximité. Ainsi, il est avantageux que les groupes organiques de type X correspondent à des groupes présentant la majorité des liaisons covalente avec les hydrogènes susceptibles d'être engagés dans les liaisons hydrogène avec Y, pour qu'ainsi une partie des groupes X présents dans les molécules de polymère les plus proches de la surface puisse développer également des liaisons hydrogène avec le support pour augmenter significativement la cohésion du film avec le support. Le support pourra par exemple être choisi parmi le verre, le mica, le silicium, présentant généralement une couche d'oxyde, ou encore l'oxyde d'indium étain (ITO).

Lorsqu'il est question d'une étape de dépôt sur le support, le terme de support ne doit pas être entendu de manière limitative, il faut garder à l'esprit que la nature de la « surface » du « support » évolue au fur et à mesure que des dépôts successifs. Ainsi par exemple si un premier dépôt de polymère est effectué sur un support de verre, dont la surface est en verre, le second dépôt, qui correspondra par exemple à un dépôt de nanoparticules, sur le « support » sera effectué sur une surface qui correspondra à celle d'un support de verre recouvert d'un polymère. De la même manière, si un dépôt supplémentaire est effectué sur ce même support il faut comprendre que le dépôt est effectué sur la « couche » la plus externe, ici une « couche » de nanoparticules.

Ainsi l'invention correspond particulièrement à un procédé de revêtement non covalent d'un support par un film multicouche hybride organique-inorganique comportant m couches de nature organique et n couches de nature inorganique, caractérisé en ce qu'il comporte les étapes de :
(a) dépôt d'un polymère organique conjugué comportant des groupes organiques de type X sur le support ;
(b) dépôt de nanoparticules comportant un ou plusieurs groupes organiques de type Y sur le support ;
et en ce que les groupes de types X et Y sont susceptibles de développer des liaisons de type hydrogène entre eux,
et en ce que l'étape (a) est réalisée m fois et l'étape (b) n fois, m et n étant supérieurs ou égaux à 1.

Les étapes (a) et (b) sont typiquement réalisées de manière successive, ainsi que cela a précédemment été indiqué, il est en outre préférable que la première étape soit l'étape (a). Généralement les étapes (a) et (b) sont effectuées à l'aide de solutions liquides comprenant le polymère ou les nanoparticules. Ces solutions sont préparées avec un solvant adapté au composé à solubiliser ou à disperser. L'homme du métier est à même de déterminer le solvant qui peut être employé selon ce qu'il désire solubiliser ou disperser, il est recommandé de tester différents solvants en fonction de leur polarité afin de déterminer le solvant assurant une solubilisation ou une dispersion suffisante.

Il est recommandé de choisir un solvant dans lequel il est possible de solubiliser le polymère comportant des groupes de type X à une concentration au moins égale à 0,1 g/L. Généralement il est possible d'utiliser le même solvant ou un solvant de polarité similaire que celui utiliser pour le polymère conjugué ne comportant pas de groupe X et notamment lorsque leur masse moléculaire est proche, *i.e.* la différence est au plus égale à 10%. Par exemple, dans le cas des poly(alkylthiophène)s, les solvants appropriés sont plutôt aprotiques et apolaires. Ainsi par exemple le poly(hexylthiophène) régiorégulier, avec typiquement Mₙ proche de 12800 g/mol, comportant des fonctions diaminopyrimidine peut être solubilisé dans chloroforme.

Il est recommandé de choisir un solvant permettant une dispersion des nanoparticules à une concentration au moins égale à 0,1 g/L. Typiquement les solvants adaptés sont plutôt aprotiques et polaires, il peut par exemple s'agir du N,N-diméthylformamide (DMF). Afin de contre-balancer le pouvoir accepteur de liaisons hydrogènes de certains solvants, comme le DMF, une faible quantité de méthanol est généralement ajouté, typiquement 10% en volume. Ainsi par exemple des NPs de CdSe fonctionnalisés avec de la 1-(6-mercaptohexylthymine) peuvent être dispersés dans un mélange N,N-diméthylformamide/méthanol (10/1 en volume). Les solvants employés lors de la synthèse des nanoparticules que l'utilisateur souhaite employer sont souvent adaptés pour la réalisation de dispersion, il est utile de se référer aux modes opératoires associés. S'agissant des nanoparticules/nanocristaux il est souvent avantageux d'appliquer un traitement ultrasonore à la solution afin de favoriser la dispersion.

Les étapes (a) et (b) peuvent être notamment réalisées par vaporisation des solutions sur le support. Avantageusement, les étapes (a) et (b) sont réalisées par trempage du support dans la solution correspondante, ce type de procédure, connu sous le nom de dépôt couche par couche (LBL ou « layer by layer »), est particulièrement adapté car il permet un contrôle sur la quantité de composé qui sera déposé sur le support. Typiquement le support est plongé dans la solution durant un temps variable qui peut être compris entre quelques minutes (par exemple 5 minutes en utilisant une concentration de 0,25 g/L), et quelques dizaines de minutes (par exemple 45 minutes en utilisant une concentration de 4 g/L), selon la quantité de composé que l'utilisateur souhaite déposer sur le support et par conséquent selon l'épaisseur qu'il souhaite donner à la couche. L'épaisseur de chacune des couches peut facilement être modulée en variant le temps de trempage, et la concentration des espèces à déposer dans le solvant. Une latitude importante est donnée à l'utilisateur avec cette technique selon le type d'application qu'il envisage, l'homme du métier pourra à ce titre se référer à la littérature et par exemple à Adv. Mater. 2004, 16, p. 823 qui illustre, pour le poly(p-phénylène vinylène), le rapport épaisseur de la couche mince de polymère/durée de trempage.

Entre chacune des étapes il est possible de rincer le support avec un solvant, ceci permet avantageusement de supprimer le surplus de matière qui n'adhère pas au support, et en particulier dans le cas des NPs, de se débarrasser d'un solvant accepteur de liaisons hydrogène, comme le DMF. Le solvant employé correspondra généralement à celui de la dernière solution qui a été employée ou à un autre solvant et particulièrement à un solvant volatile ne développant pas de liaisons hydrogène avec les couches déjà présentes sur le support. Il est également possible d'évaporer le solvant résiduel éventuellement présent à l'issu des étapes de dépôt. Pour cela, il est possible d'attendre l'évaporation su solvant dans les conditions normales de température et de pression (CNTP) ou d'employer un flux de gaz, généralement un gaz inerte, de réduire la pression ambiante ou d'augmenter la température.

Généralement m et n seront tels que le film multicouche ait une épaisseur totale comprise entre quelques nanomètres ou quelques dizaines de nanomètres, m et n sont égaux à 1 dans ce cas, et jusqu'à quelques centaines de nanomètres avec en général des valeur de m et n supérieures à 10. Des épaisseurs aux alentours de 100 nm sont typiquement atteintes pour des valeurs de m et n comprises entre 6 et 10. Des mesures peuvent bien entendu être effectuée pour contrôler l'épaisseur du film en utilisant un profilomètre, ou la méthode de diffusion des rayons X aux petits angles. Utilement l'homme du métier pourra se référer à l'exemple décrit plus loin.

L'invention concerne également un film susceptible d'être obtenu selon les dispositions exposées ci-dessus. Plus généralement l'objet de l'invention correspond à un film multicouche hybride organique-inorganique comportant :
- m couches de polymère organique conjugué comportant des groupes organiques de type X ;
- n couches de nanoparticules comportant un ou plusieurs groupes organiques de type Y ;
les groupes de types X et Y étant susceptibles de développer des liaisons de type hydrogène entre eux le polymère organique conjugué comportant des groupes organiques de type X étant le poly(3-hexylthiophène) fonctionnalisé par la fonction diaminopyrimidine.

Les éléments du film pouvant notamment être tels que définis précédemment.

L'invention concerne également un support, tel que définis plus haut, recouvert d'un film tel que défini précédemment.

L'objet de l'invention s'étend également aux dispositifs électroniques, et notamment aux dispositifs photovoltaïques, comportant un film tel que présenté précédemment. Un tel dispositif comprendra avantageusement :
- un support recouvert en partie d'un film, tels que précédemment exposé ;
- une couche métallique, par exemple Al, Ag, Ca ou Au, sur une partie au moins du film ;
- des contacts électriques établis entre une partie du support non recouverte de film, qui constitue l'anode, et la couche métallique, qui constitue, la cathode (e.g. aluminium).

Lors de l'emploi de tels dispositifs dans le domaine du solaire, il est avantageux d'intégrer une couche supplémentaire entre le support recouvert d'un film et la couche métallique, il s'agit généralement d'une couche améliorant le facteur de forme (amélioration du V_{oc}) et donc améliorant le rendement du dispositif de conversion de la cellule solaire. Cette couche est par exemple réalisée avec du LiF comme indiqué dans la littérature (Appl. Phys. Lett. vol 80, p1288).

Typiquement un tel dispositif sera une cellule photovoltaïque et particulièrement une cellule photovoltaïque de type hétérojonction en volume comprenant au moins deux électrodes reliées électriquement entre elles par le film conforme à l'invention. Les électrodes peuvent être indépendamment conductrices ou semi-conductrices. Typiquement, une électrode conductrice comprend une surface métallique de métaux comme l'or, le calcium, l'aluminium, l'argent, le magnésium, le chrome, le lithium, ou d'alliages de métaux. Elle peut également comprendre un empilement de couches métalliques et/ou d'oxyde conducteur comme In₂O₃/SnO₂. Elle peut éventuellement être recouverte d'un polymère conducteur comme le polypyrrole, polythiophènes y compris PEDOT /PSS (poly(3,4-ethylènedioxythiophène/polystyrènesulfonate) type Baytron®, polyanilines ou leurs dérivés. Typiquement, une électrode semi-conductrice comprend du silicium, AsGa, Ge, SiC. L'électrode semi-conductrice peut éventuellement être déposée sur un matériau isolant tels que la silice, l'alumine ou le verre. Avantageusement, une des électrodes au moins est transparente.

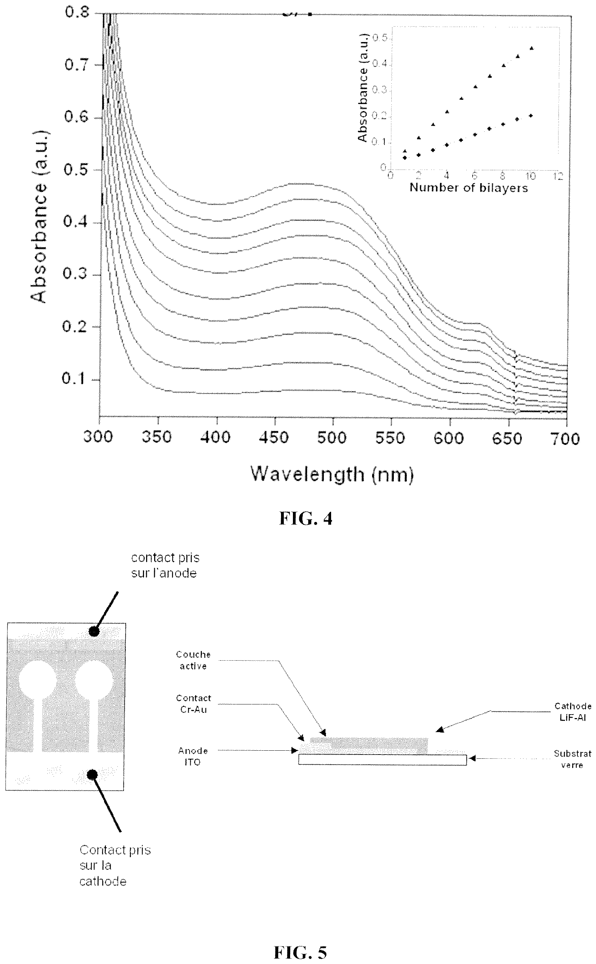

Une telle cellule peut être réalisée à partir d'un support en verre comportant une couche en ITO préalablement gravés avec de l'eau régale pour en enlever une partie, des plots Cr-Au sont ensuite déposés sur l'ITO et sur le verre. Une couche de PEDOT-PSS (poly(3,4-éthylènedioxythiophène)-poly(styrène sulfonate)) peut éventuellement être déposée par spin-coating. Les plots sur le verre sont dégagés. La couche active, qui correspond au film exposé précédemment, est ensuite déposée par trempage couche par couche. Une fois la couche active déposée les plots sont dégagés et la face arrière est nettoyée. Les supports sont ensuite placés dans un bâti dans lequel est déposé la couche LiF-Al, dont l'épaisseur varie généralement entre 1,3 et 70 nm, par évaporation thermique sous vide au travers d'un masque définissant ainsi deux cellules par support dont la surface active a une surface modulable selon le souhait de l'utilisateur. Lors de l'illumination, le courant généré est récupéré par les contacts pris sur l'aluminium (sur les plots en or) et sur l'ITO (sur les plots en or). Utilement le lecteur se réfèrera aux exemples et notamment à la figure 5.

Enfin l'invention concerne l'utilisation des films, supports recouverts de films et dispositifs tels que décrit précédemment, dans le domaine de l'électronique et notamment photovoltaïque et particulièrement dans une cellule photovoltaïque.

L'invention expose une nouvelle méthode de fabrication de couches minces contenant des NCs ou NPs inorganiques dans un polymère conjugué. Elle est basée sur l'utilisation d'interactions non-covalentes entre les NCs ou NPs et le polymère conjugué. Selon les dispositions exposées, un film mince composé de NCs et d'un polymère conjugué peut être réalisé par simple trempage répété d'un support dans une solution contenant le polymère puis dans une solution contenant les NCs. Les solvants utilisés dans le cadre de l'invention sont généralement de type organique et sont donc compatibles avec les polymères conjugués et les NCs/NPs. L'épaisseur totale du film est contrôlée à l'échelle nanométrique par le nombre de couches déposées ainsi que par des paramètres tels que la concentration des solutions et temps de trempage du support. L'avantage de la technique repose également sur le fait que le dépôt d'une couche d'accroche sur le substrat n'est pas nécessaire, le polymère fonctionnalisé assurant la double accroche du polymère sur la surface du support et des NCs sur le polymère. A la différence du procédé de dépôt par spin-coating, cette méthode est très économique puisque seul le matériau déposé est consommé. En outre, le film résultant ne présente pas d'agrégats dus à une démixtion naturelle des deux composants NCs et polymère conjugué grâce à l'existence de liaisons hydrogènes. La présence de liaisons de force intermédiaire, c'est-à-dire plus faibles que des liaisons covalents et plus fortes que des liaisons Van der Waals, donne par ailleurs plus de souplesse en terme d'auto-organisation du matériau organique/inorganique et permettent de modifier sa morphologie par un traitement de type recuit thermique après dépôt.

L'invention sera mieux comprise à la lecture du mode de réalisation présenté ci-après et qui n'a d'autre but que son illustration et ne vise aucunement à en limiter la portée.

La figure 1, correspond à la représentation de deux unités monomériques d'un polymère de 3-hexylthiophène comportant des groupes organiques de type X, l'une des unités monomérique est un 3-hexylthiophène lié à une 6-oxy-2,4-diaminopyrimidine à l'extrémité de la chaîne hexyle.

La figure 2, correspond à la représentation schématique de l'établissement d'une liaison hydrogène triple entre le groupement DAP (diaminopyrimidine) présent en bout de chaine alkyle du polymère et le groupement Thy (thymine) introduit par réaction d'échange à la surface de NCs de CdSe.

La figure 3 correspond à une image de microscopie électronique à balayage d'un dépôt d'une seule bicouche P3HT-DAP/CdSe-Thy sur un substrat en ITO.

La figure 4 représente le spectre d'absorption UV-vis enregistré au cours du dépôt couche par couche de l'hybride pour chaque bicouche P3HT-DAP/CdSe-Thy, l'absorbance (en unité arbitraire a.u.) à une longueur d'onde (wavelenght) 500 nm étant caractéristique du polymère et l'absorbance à 622 nm caractéristique des NCs, en encart apparaît l'évolution en fonction du nombre de bicouches (number of bilayers) polymère/NP.

La figure 5 correspond à la représentation schématique d'une cellule photovoltaïque.

La figure 6 correspond aux Courbes I-V (courant - current - en ampère en fonction du voltage en volt) enregistrées pour une cellule composée de 25 bicouches de P3HT-DAP/CdSe-Thy (diamètre NCs = 5,7 nm), la courbe en pointillé correspond la caractéristique I-V de la cellule dans le noir, en trait plein apparait celle de la cellule sous illumination à une puissance d'illumination Pᵢₗₗ = 100mW/cm².

### EXEMPLES

### I - Synthèse d'un copolymère à base de poly(3-hexylthiophène) comportant des fonctions diaminopyrimidine (P3HT-DAP)

### I.1- Synthèse d'un copolymère fonctionnalisable : poly (3-hexylthiophène-co-3-(6-bromohexyl) thiophène)

Du 3-(6-Bromohexyl)thiophène a tout d'abord été synthétisé par réaction entre le 3-bromothiophène et le 1,6-dibromohexane selon le protocole décrit par de Zhai et al [Macromolecules, 2003, 36, p. 61]. Le montage expérimental est au préalable mis sous vide puis sous atmosphère inerte (Argon). Dans un ballon tricol de 250 ml on été placés du 3-bromothiophène (5,38g ; 33 mmol) et 30 ml d'hexane anhydre, le milieu a été refroidit à -40°C à l'aide d'un bain d'acétone/azote liquide et agité pendant 15 minutes. Par le biais d'une ampoule à addition a alors été ajouté du n-butyllithium à 1,6 M dans l'hexane (20 ml ; 32 mmol) goutte à goutte durant environ 1h. Après 15 minutes d'agitation, 5 ml de THF anhydre ont alors été ajoutés goutte à goutte avec une seringue pendant environ 5 min, puis le milieu réactionnel a été placé sous agitation pendant une heure à -40 °C. Pendant ce temps un tricol de 250ml purgé à l'argon dans lequel a été placé du 1,6-dibromohexane (50 ml ; 320 mmol) est préparé. Après une heure la température du milieu réactionnel n'a plus été contrôlée, lorsqu'elle a atteint la température ambiante le mélange a été transféré dans le 1,6-dibromohexane par le biais d'un coude, le tout sous flux d'argon. Après agitation à température ambiante pendant 2h, la solution a été extraite avec de l'éther diéthylique (3x50ml) et la phase organique lavée avec de l'eau distillé (3x50 ml). Les fractions organiques ont été séchées sur sulfate de magnésium, et les solvants évaporés à pression réduite. Le 3-(6-bromohexyl)thiophène a ensuite été récupéré par distillation sous vide.
C₁₀H₁₅BrS : 247,2 g/mol - Rendement : 50%,
RMN ¹H (CDCl₃, 200MHz) δ (ppm): 7,26-7,22 (m, 1H); 7,13-7,10 (m) ; 6,94-6,92 (m, 2H) ; 3,40 (t, 2H) ; 2,79 (td) ; 2,64 (t, 2H) ; 1,86 (q, 2H) ; 1,64 (q, 2H) ; 1,51-1,30 (m, 4H).
RMN ¹³C (CDCl₃, 200MHz) δ (ppm): 142,78; 128,13; 125,10; 119,83 ; 33,92 ; 32,65 ; 30,26 ; 30,05 ; 28,32 ; 27,90.

Analyse élémentaire : Calculée : C, 48,5% ; H, 6,47% ; S, 12,94% ; Br, 32,36%. Valeurs expérimentales : C, 49,48% ; H, 6,43% ; S, 11,75% ; Br, 32,33%.

La synthèse du 2,5-dibromo-3-(6-bromohexyl)thiophène a ensuite été réalisée à partir du 3-(6-bromohexyl)thiophène. Dans un tricol, purgé à l'argon, ont été introduits du 3-(6-bromohexyl)thiophène (3,0g ; 12 mmol), du N-Bromosuccinimide (4,3g; 24 mmol), du THF anhydre (15ml) et de l'acide acétique (15ml), le milieu réactionnel a alors été agité pendant une heure. Le mélange a ensuite été extrait à l'éther diéthylique puis lavé à l'eau et avec NaHCO₃ jusqu'à pH neutre. La phase organique a ensuite été séchée sur sulfate de magnésium puis concentrée.
C₁₀H₁₃Br₃S : 404,9 g/mol - Rendement : 83%.
RMN ¹H (CDCl₃, 200MHz) δ (ppm): 6,77 (s, 1H); 3,41 (t, 2H); 2,52 (t, 2H); 1,86 (q, 2H); 1,64-1,26 (m, 6H). Pics attribués à l'isomère de position 5-bromo-2-(6-bromohexyl) thiophène (≈7%): 6,86 (s) et 2,73 (t).
RMN ¹³C (CDCl₃, 200MHz) δ (ppm):142,47 ; 130,74 ; 110,32 ; 107,95 ; 33,81 ; 32,53 ; 29,23 ; 29,17 ; 28,04 ; 27,76.

Afin d'effectuer la polymérisation le 2,5-dibromo-3-hexylthiophène a été préparé de manière similaire au protocole précédent, à partir du 3-hexylthiophène (2g, 12 mmol) et du NBS (4,2g ; 24 mmol) et un mélange THF anhydre (10 ml) acide acétique (10 ml).
C₁₀H₁₄Br₂S : 326,1g/mol - Rendement : 81%.
RMN ¹H (CDCl₃, 200MHz) δ (ppm): 6,76 (s, 1H); 2,50 (t, 2H); 1,53 (q, 2H); 1,38-1,22 (m, 6H), 0,88 (t, 3H).
RMN ¹³C: (CDCl₃, 200MHz) δ (ppm): 142,85; 130,83; 110,29; 107,90 ; 31,55 ; 29,52 ; 29,43 ; 28,78 ; 22,57 ; 14,09.

Ces deux monomères ont ensuite été copolymérisés par la méthode GRIM (métathèse de Grignard) pour conduire à un copolymère régiorégulier statistique dont le rapport en motif hexylthiophène/bromohexylthiophène est de 6 pour 1. Ce polymère a ensuite été fractionné en utilisant une séquence de solvants afin de réduire sa polydispersité, et par la suite la fraction extraite par le dichlorométhane a été utilisée pour la post-fonctionnalisation (Mₙ = 12800 g/mol; Mₚ = 22200 g/mol ; Iₚ = 1,73).

La synthèse a été faite dans un montage sous atmosphère inerte (Argon). Dans un premier ballon tricol a été placé du 2,5-dibromo-3-(6-bromohexyl)thiophène (1,17 g ; 2,8 mmol) auquel ont été ajoutés 10 ml de THF anhydre puis du chlorure de tertiobutyle magnésium (1,73 ml ; 2M dans l'éther diéthylique), le mélange a alors été chauffé à reflux pendant 2h. Dans un second tricol contenant du 2,5-dibromo-3-hexylthiophène (2,8g ; 8,6 mmol) dans du THF anhydre (30 ml) a été ajouté du chlorure de tertiobutyle magnésium (5,22 ml ; 2M dans l'éther diéthylique), le mélange résultant a ensuite été chauffé à reflux pendant 2h. Le contenu du premier tricol a été transféré dans le second par le biais d'une canule sous flux d'argon. La polymérisation a ensuite été initiée par l'ajout de chlorure de nickel (II) 1.3-(diphénylphosphino)propane (Ni(dppp)Cl₂) (32mg, 0.059 mmol), et le milieu réactionnel maintenu sous agitation pendant une heure à reflux. Après refroidissement du milieu jusqu'à température ambiante, le polymère a été précipité dans 200ml de méthanol. Le polymère a ensuite été lavé trois fois au méthanol.

Le rapport initial des monomères introduits est de 1 équivalent molaire de 3-(6-bromohexylthiopène) pour 3 équivalents molaires de 3-(hexylthiophène). La proportion de motifs 3-(6-bromohexyl)thiophène intégrés dans les chaînes du copolymère est de 1 pour 5 ainsi que cela a été déterminée par l'intégration des pics caractéristiques en RMN du proton et confirmée par l'analyse élémentaire.
RMN ¹H (CDCl₃, 200MHz) δ (ppm): en souligné figurent les pics spécifiques au motif 3-(6-bromohexyl)thiophène 6,98 (s, 1H) ; 3,43 (t, 2H) ; 2,80 (t 2H) ; 1,90 (m, 2H) ; 1,71 (m, 2H) ; 1,37 (m, 6H) ; 0,91 (t, 3H).
RMN ¹³C (CDCl₃, 200MHz) δ (ppm) : en souligné figurent les pics spécifiques au motif 3-(6-bromohexyl)thiophène 139,86; 133,65; 130,42; 128,57 ; 33,92 ; 32,69 ; 31,68 ; 30,49 ; 29,44 ; 29,25 ; 28,60 ; 27,97 ; 22,65 ; 14,13.

Analyse élémentaire : calculée : C, 66,98% ; H, 7,72% ; Br, 7,44% ; S, 17,86%. Valeurs expérimentales: C, 65,98%; H, 7,74%; Br, 7,32%; S, 16,33%.
IRTF-ATR: 3040w, 2942m, 2920s, 2850s, 2784w, 1504m, 1452s, 1374m, 1254w, 1198w, 1094s, 822s, 724m.

A l'issue de la copolymérisation le polymère possède une polydispersité (Mₙ = 9200 g/mol ; Mₚ = 23500 g/mol ; Iₚ = 2,57) qui a été réduite par des extractions sélectives en masses molaires. Le polymère obtenu a été séché sous pression réduite et la poudre obtenue broyée finement avant d'être introduite dans une cartouche de cellulose placée sur un extrateur de Soxhlet. L'extraction à chaud du polymère a été réalisée alors grâce à une séquence de solvants utilisés classiquement pour les polyalkylthiophènes, dans l'ordre : acétone, hexane, dichlorométhane, tétrahydrofurane et chloroforme. L'extraction des oligomères a été faite par l'acétone et l'hexane, les plus longues chaines extraites par le THF et le chloroforme, le dichlorométhane a permi de récupérer les chaines de taille intermédiaires. Cette séquence est précédée d'une extraction à chaud au méthanol afin d'enlever toute trace de catalyseur et les monomères qui n'ont pas réagi.

### I.2- Post-fonctionnalisation du poly (3-hexylthiophène-co-3-(6-bromohexyl)thiophène)

La fonctionnalisation de ce polymère par les fonctions diaminopyrimidine (DAP) a été obtenue par réaction du copolymère avec la 2,4-diamino-6-hydroxypyrimidine en milieu basique, la réaction consiste à substituer les bromes en bout de chaine alkyle par des fonctions oxy-diaminopyrimidine. Au final, le copolymère obtenu présente un rapport de motifs hexylthiophène /DAP-hexylthiophène de 9 pour 1. Le copolymère obtenu est soluble dans le chloroforme.

De manière plus précise, la synthèse a été réalisé en ajoutant 12 ml de DMSO anhydre, 39,8 mg de K₂CO₃ et 20 ml de THF anhydre a un mélange de poly (3-hexylthiophène-*co*-3-(6-bromohexyl)thiophène) (Mₙ = 12800 g/mol, 55,2 mg) et de 2,4-diamino-6-hydroxypyrimidine (357,2 mg, 2,83 mmol) préalablement placé dans un ballon tricol sous argon. Le mélange résultant a été placé sous agitation et porté à reflux pendant 18 h. Le milieu réactionnel a ensuite été précipité dans du méthanol et le polymère filtré et lavé au méthanol.
RMN ¹H (CDCl₃, 200MHz) δ (ppm): 6,98 (s, 1H) ; 5,21 (s, 1H) ; 4,67 (s, 2H) ; 4,48 (s, 2H) ; 4,15 (t, 2H) ; 2,80 (t, 2H) ; 1,70 (m, 2H) ; 1,36 (m, 6H) ; 0,91 (t, 3H).
IRTF-ATR: 3464w, 3332w, 3162w, 3048w, 2920s, 2850s, 2642w, 1580s, 1502m, 1450s, 1420s, 1372m, 1250w, 1196m, 1150w, 1014m, 820s, 796s, 720m, 660w.

### II - Synthèse du ligand 1-(6-mercaptohexyl)thymine (MHT)

La synthèse de ce ligand a été réalisée selon les protocoles de Nowick [J. Am. Chem. Soc. 1993, 115, p. 7636] et Matsuura [Langmuir 1997, 13, p. 814]. Selon ce mode opératoire la 1-(6-bromohexyl)thymine a tout d'abord été synthétisée par réaction de la thymine protégée avec du 1,6-dibromohexane puis la fonction thiol a été introduite par réaction avec la thiourée pour donner le 1-(6-mercaptohexyl)thymine (MHT).

### III - Synthèse des nanocristaux de CdSe

Le protocole de synthèse qui a été employé est dérivé de la méthode décrite dans Angew. Chem. Int.Ed. 2002, 41, p. 2368. Les NCs qui ont été obtenus ont des tailles comprises entre 3 et 6 nm, leur diamètre a été déterminé par microscopie électronique à transmission (MET).

### Synthèse de nanocristaux de CdSe de 3,7 nm de diamètre

Dans un ballon tricol surmonté d'un réfrigérant et dégazés sous vide primaire pendant 15 minutes ont été placés 0,4 mmol d'oxyde de cadmium (CdO), 10 mmol d'acide stéarique, 10 mmol d'oleylamine et 20 ml d'octadécène (ODE), le ballon a été mis sous atmosphère inerte (Argon) et chauffé à 250°C. Une solution contenant 5 ml d'une solution de Se dissous dans de la trioctylphosphine (TOP-Se) de concentration 0,4 M et 8,3 ml d'ODE, a alors été injectée rapidement dans le milieu.

### Synthèse de nanocristaux de CdSe de 4,5 nm de diamètre

Le protocole de synthèse similaire au précédent, il a été modifié de la façon suivante : 0,4 mmol de CdO, 10 mmol d'acide stéarique, 14 ml d'oleylamine, 9 ml d'ODE, la solution injectée comprenait 5 ml d'une solution TOP-Se à 0,4 M diluée avec 3,3 ml d'ODE et 5 ml d'oleylamine.

### Synthèse de nanocristaux de CdSe de 5,8 nm de diamètre

Le protocole de synthèse similaire au précédent, les quantités de réactifs ont été modifiées de la façon suivante : 0,8 mmol de CdO, 40 mmol d'acide stéarique, 5,3 ml d'ODE pas d'oleylamine, la solution injectée comprenait 1 ml d'une solution TOP-Se à 0,4 M diluée avec 1,7 ml d'ODE, par ailleurs la température de la synthèse était de 300°C.

### IV - Echange des ligands à la surface des nanocristaux de CdSe : obtention des NCs fonctionnalisés CdSe-Thy

Les nanocristaux de CdSe, recouverts par leur ligand d'origine (acide stéarique) ont été soumis à une réaction d'échange réalisée en solution dans le chloroforme par l'ajout d'un excès connu en ligand MHT, de 20 à 50 fois le nombre de moles de ligand stéarate en surface des nanocristaux. Les nanocristaux fonctionnalisés par le MHT perdent leur solubilité dans le chloroforme, mais sont solubles dans des solvants tels que le diméthylsulfoxyde et le N,N-diméthylformamide. Le taux d'échange avec le MHT, déterminé par spectroscopie RMN ¹H et thermogravimétrie, dépend des conditions réactionnelles.

A 30 ml d'une solution de de nanocristaux de CdSe (diamètre =6,1 nm) dans le chloroforme (0,674.10⁻⁶ M) ont été ajouté 1-(6-mercaptohexyl)thymine (67,2 mg, 0,28 mmol), puis, le mélange réactionnel a été chauffé à 50 °C pendant 3 jours. A l'issu de l'échange les nanocristaux ont été isolés par filtration car leur solubilité est faible dans le chloroforme. Le filtrat a été lavé au chloroforme pour enlever l'excès de 1-(6-mercaptohexyl)thymine et l'acide stéarique échangé. Les nanocristaux ont ensuite été solubilisés dans du DMSO-d6 pour déterminer le taux d'échange par ¹H RMN. Dans ce cas le taux de 1-(6-mercaptohexyl)thymine à la surface des nanocristaux est de 20%.

Le taux peut être augmenté en réalisant l'échange dans un four à micro-ondes. Ainsi, après avoir réalisé un mélange de 1-(6-mercaptohexyl)thymine (70,1 mg, 0,29 mmol) et de 17 ml d'une solution de nanocristaux de CdSe (diamètre = 6,1 nm) dans le chloroforme (1,27.10⁻⁶ M) le milieu réactionnel a été et on placé dans un four à micro-onde auquel a été donné pour consigne une température de 45°C pour une puissance de 60W. La montée en température a été programmée sur un laps de temps de 15 min, puis le milieu placé une heure à 45°C et pour terminer une descente à température ambiante en 20 min. Les nanocristaux ont purifiés de la même manière que pour la réaction d'échange par voie classique. Cette fois ci le taux d'échange a été estimé à 70%.

### V - Synthèse de NPs d'Au

Le protocole de synthèse qui a été employé suit les méthodes décrites dans Chem. Commun. 1994, p. 801 & J. Phys. Chem. 2003, 107, p. 7406. Les NPs qui ont été obtenues ont des tailles comprises entre 2,5 et 6 nm, déterminées par MET (microscopie électronique à transmission).

### VI - Echange des ligands à la surface des nanoparticules d'Au : obtention des NPs fonctionnalisés Au-Thy

Les NPs d'Au, recouvertes par leur ligand d'origine (octanethiol) ont été soumises à une réaction d'échange réalisée par l'ajout d'un excès connu en ligand MHT (50 fois le nombre de moles des ligands d'origine, octanethiol). Les NPs fonctionnalisées par le MHT sont solubles dans des solvants tels que le diméthylsulfoxyde et le N,N-diméthylformamide. Le taux d'échange avec le MHT dépend des conditions réactionnelles et est déterminé par spectroscopie RMN ¹H. Pour une réaction d'échange conduite à 45°C dans le chloroforme pendant 3 h, le taux d'échange qui a été obtenu est d'environ 80%.

### VII - Elaboration de films minces de NCs de CdSe - P3HT par la technique du dépôt couche par couche

Une solution du polymère P3HT-DAP dans le chloroforme (1g/L) et une dispersion des nanocristaux CdSe-Thy dans un mélange N,N-diméthylformamide : méthanol (10 :1 ; environ 0,2 g/L) ont été introduites dans deux béchers. Une lame de verre parallélépipédique de 1,1 mm d'épaisseur sur l'une des grandes surfaces de laquelle a été déposé de l'ITO (oxyde d'indium et d'étain, de résistivité de surface de 8-12 Ω/sq, frourni par ALDRICH®) préalablement nettoyé par immersion pendant 15 min sous ultrasons dans l'éthanol puis 15 min aux ultrasons dans l'acétone avant d'être séché à l'étuve, a été employé pour effectuer le dépôt. La première couche a été réalisée par trempage du support dans la solution de polymère pendant 2 min puis rinçage avec du chloroforme et séchage sous flux d'argon. Le support a ensuite été immergé dans la solution de NCs de CdSe pendant 5 min puis rincé avec du chloroforme et séché sous flux d'argon. En figure 2 est représenté schématiquement l'interaction entre un nanocristal et une molécule de polymère.

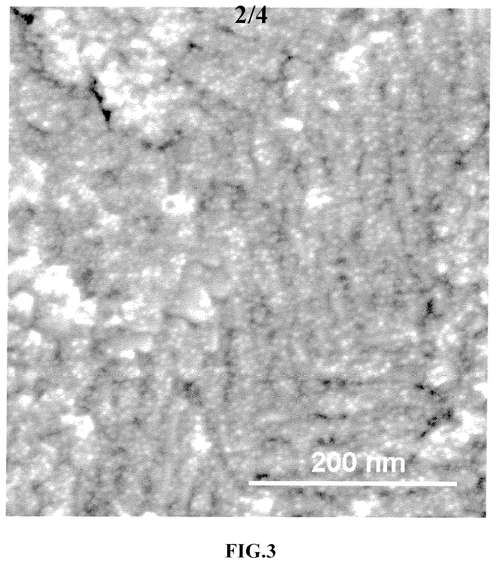

Le support, après dépôt d'une couche de polymère et d'une couche de NCs, a été observé par microscopie électronique pour vérifier la dispersion très homogène des NPs sur le support, l'image obtenues est présentée à la figure 3, sur laquelle, la structure irrégulière qui correspond à la surface rugueuse de l'ITO peut être distinguée en arrière plan, les nanocristaux de CdSe apparaissant sous forme de petits grains blancs au premier plan. L'opération de trempage alternativement dans ces deux solutions a été répétée jusqu'à l'obtention de 25 couches de chacune des espèces. La croissance du film a été suivie par spectroscopie d'absorption UV-vis ainsi que le montre la figure 4.

### VIII - Elaboration de films minces de NPs d'Au - P3HT par la technique du dépôt couche par couche

Le protocole est le même que celui décrit en VII en utilisant une dispersion de NPs Au-Thy au lieu de NCs CdSe-Thy.

### IX - Dispositif photovoltaïque

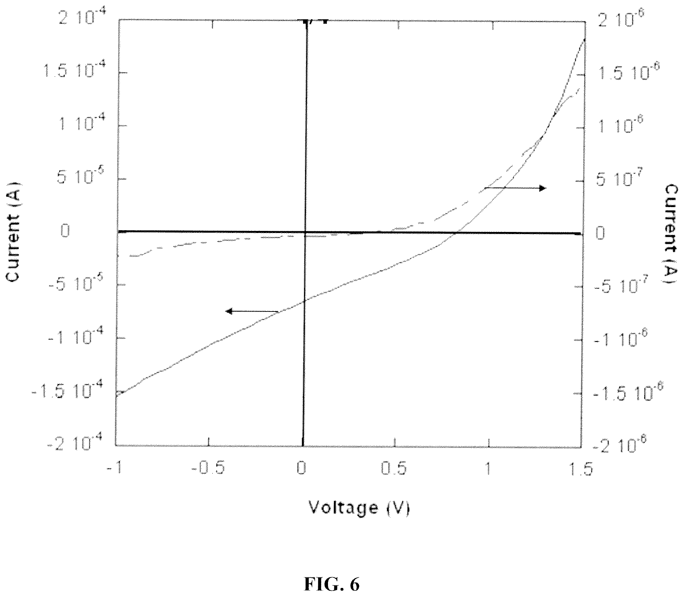

Pour réaliser une cellule photovoltaïque, un film composé de 25 bicouches de P3HT-DAP/CdSe-Thy (diamètre NCs = 5,7 nm, couverture de la surface en MHT = 68 %, en stéarate 32%) a tout d'abord été déposé sur un support en verre recouvert en partie d'ITO, et présentant deux contacts électriques de type Cr-Au (figure 5), par la méthode du dépôt couche par couche selon les modalités présentées en VII. Une couche de LiF (1,3 nm) puis d'aluminium (70 nm) ont été déposées par évaporation thermique sous vide au travers d'un masque permettant la définition de la surface active de la cellule (2,8 cm²). Le dispositif préparé correspond à celui qui est représenté en figure 5. La cellule solaire ainsi réalisée a été testée sous lumière blanche AM 1,5 avec une puissance d'illumination de 100 mW/cm². Les résultats obtenus sous forme de courbes intensité-tension (I=f(V)) révèlent un effet photovoltaïque ainsi que cela apparaît en figure 6. De ces courbes caractéristiques peuvent être extraites les valeurs de potentiel en circuit ouvert V_{oc}=0,82 V, de densité de courant de court-circuit J_{sc}= 6,5.10⁻⁵ A/cm², ainsi qu'une valeur de 0,28 pour le facteur de remplissage FF = J_{M}V_{M}(J_{sc}V_{oc}) avec J_{M} et V_{M} étant des valeurs de courant et de potentiel résultant la puissance maximale fournie par la cellule solaire. A partir de ces valeurs, il est possible de calculer un rendement de conversion de la cellule (η) de 0,015% selon la formule η=J_{sc}V_{oc}FF/P avec P signifiant la puissance d'irradiation intégrée pour la surface du dispositif.

## Revendications

1. Procédé de revêtement non covalent d'un support par un film hybride organique-inorganique comportant les étapes de :
- dépôt d'un polymère organique conjugué comportant des groupes organiques de type X sur le support ;
- dépôt de nanoparticules comportant un ou plusieurs groupes organiques de type Y sur le support ;
les groupes de types X et Y étant susceptibles de développer des liaisons de type hydrogène entre eux,
le polymère organique conjugué comportant des groupes organiques de type X étant le poly(3-hexylthiophène) fonctionnalisé par la fonction diaminopyrimidine .

2. Procédé selon la revendication 1, **caractérisé en ce que** les étapes de dépôt sont répétées de manière alternative.

3. Procédé selon les revendications 1 et 2, dans lequel X et Y présentent en leur sein, pour X la structure carbonée de formule (I) : 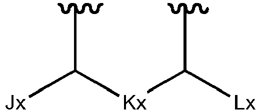 et pour Y la structure carbonée de formule (II) : 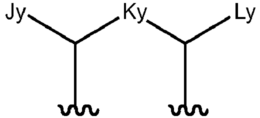 dans lesquelles
- des liaisons hydrogène sont susceptibles de se former dans au moins deux des couples Jx/Jy, Kx/Ky, Lx/Ly ;
- pour le couple Jx/Jy, un des J représente un N ou un O lié de manière covalente à un hydrogène et l'autre représente un N ou un O comportant une liaison de type π ;
- pour le couple Kx/Ky, un des K représente un atome d'azote lié de manière covalente à un hydrogène, et l'autre représente un N comportant une liaison de type π ;
- pour le couple Lx/Ly, les L représentent indépendamment des atomes d'hydrogène, de carbone, un N ou un O lié de manière covalente à un hydrogène, un N ou un O comportant une liaison de type π.

4. Procédé selon la revendication 3, dans lequel X et Y correspondent au couple diaminopyrimidine/thymine.

5. Procédé selon la revendication 1, dans lequel la quantité d'unités monomériques modifiées qui comporte le groupe X est comprise entre 5 et 50 %.

6. Procédé selon l'une quelconque des revendications précédentes, **caractérisé en ce que**, les nanoparticules présentent un coeur inorganique, constitué d'au moins un métal et/ou d'au moins un composé semi-conducteur comprenant au moins un métal, auquel est lié au moins un ligand, de nature organique, comportant un groupe organique de type Y.

7. Procédé selon la revendication 6, **caractérisé en ce que** le métal et/ou au moins un composé semi-conducteur comprenant au moins un métal est choisi parmi CdSe, CdTe, ZnO, PbSe, PbS, InP, InN, CulnS₂, CulnSe₂, Cu(ln,Ga)Se₂, GaAs, InGaAs, Si, Ge, Au, Ag et Pt.

8. Procédé selon les revendications 6 et 7, **caractérisé en ce que** le ligand est de formule (III) :
BG - (SG)ₚ - Y
dans laquelle :
- BG représente un groupe de liaison susceptible de se lier aux nanoparticules ;
- SG représente un groupe espaceur ;
- p est égal à 0 ou 1.

9. Procédé selon la revendication 8, **caractérisé en ce que** BG est un thiol, un dithiol, un carbodithioate, un dithiocarbamate, un xanthate, un acide carboxylique, un acide dicarboxylique, un acide phosphonique, un acide diphosphonique, un acide sulfonique ou un acide hydroxamique.

10. Procédé selon les revendications 8 et 9, **caractérisé en ce que** l'espaceur est de nature aliphatique.

11. Procédé selon l'une quelconque des revendications précédentes **caractérisé en ce que** le support est choisi parmi le verre, le mica, le silicium présentant une couche d'oxyde, et l'oxyde d'indium étain (ITO).

12. Procédé selon l'une quelconque des revendications précédentes, **caractérisé en ce que** les étapes de dépôt sont réalisées par trempage du support dans des solutions de polymère organique conjugué comportant des groupes organiques de type X et de un ou plusieurs groupes organiques de type Y.

13. Film multicouche hybride organique-inorganique comportant :
- m couches de polymère organique conjugué comportant des groupes organiques de type X ;
- n couches de nanoparticules comportant un ou plusieurs groupes organiques de type Y ;
les groupes de types X et Y étant susceptibles de développer des liaisons de type hydrogène entre eux
le polymère organique conjugué comportant des groupes organiques de type X étant le poly(3-hexylthiophène) fonctionnalisé par la fonction diaminopyrimidine.

14. Support revêtu d'un film multicouche hybride organique-inorganique selon la revendication 13.

15. Dispositif électronique, **caractérisé en ce qu'**il comprend :
- un support revêtu en partie d'un film selon les revendications 13 et 14 ;
- une couche métallique sur une partie au moins du film ;
- des contacts électriques établis entre une partie du support non recouverte de film, qui constitue l'anode, et la couche métallique, qui constitue, la cathode.

16. Utilisation d'un film multicouche hybride organique-inorganique selon la revendication 13 ou d'un support revêtu d'un film selon la revendication 14 dans une cellule photovoltaïque.

## Patentansprüche

1. Verfahren zur nicht-kovalenten Beschichtung eines Trägers mit einem organisch-anorganischen Hybridfilm, umfassend die Schritte:
- Abscheiden eines konjugierten organischen Polymers, das organische Reste vom Typ X aufweist, auf dem Träger;
- Abscheiden von Nanopartikeln, die einen oder mehrere organische Reste vom Typ Y aufweisen, auf dem Träger;
wobei die Reste vom Typ X und Y dazu in der Lage sind, Bindungen vom Wasserstofftyp untereinander auszubilden,
wobei das konjugierte organische Polymer, das organische Reste vom Typ X aufweist, mit der Diaminopyrimidin-Funktion funktionalisiertes Poly(3-hexylthiophen) ist.

2. Verfahren nach Anspruch 1, **dadurch gekennzeichnet, dass** die Abscheidungsschritte alternierend wiederholt werden.

3. Verfahren nach den Ansprüchen 1 und 2, wobei X und Y in deren Innerem für X die Kohlenstoff-enthaltende Struktur der Formel (I): 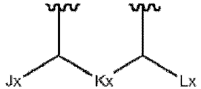 und für Y die Kohlenstoff-enthaltende Struktur der Formel (II) aufweisen: 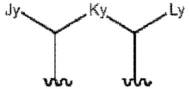 wobei
- Wasserstoffbindungen in der Lage sind, sich in mindestens zwei der Paare Jx/Jy, Kx/Ky, Lx/Ly zu bilden;
- für das Paar Jx/Jy, eines der J ein N oder O bedeutet, das kovalent an einen Wasserstoff gebunden ist, und das andere ein N oder ein O bedeutet, das eine Π-Bindung aufweist;
- für das Paar Kx/Ky, eines der K ein Stickstoffatom bedeutet, das kovalent an einen Wasserstoff gebunden ist, und das andere ein N bedeutet, das eine Π-Bindung aufweist;
- für das Paar Lx/Ly, die L unabhängig Wasserstoffatome, Kohlenstoffatome, ein N oder ein O, die kovalent an einen Wasserstoff gebunden sind, ein N oder ein O, die eine Π-Bindung aufweisen, bedeuten.

4. Verfahren nach Anspruch 3, wobei X und Y dem Diaminopyrimidin/Thymin-Paar entsprechen.

5. Verfahren nach Anspruch 1, wobei die Menge an modifizierten Monomereinheiten, die den Rest X aufweisen, zwischen 5 und 50% liegt.

6. Verfahren nach einem der vorhergehenden Ansprüche, **dadurch gekennzeichnet, dass** die Nanopartikel einen anorganischen Kern aufweisen, der aus mindestens einem Metall und/oder mindestens einer Halbleiterverbindung, die mindestens ein Metall umfasst, gebildet ist, an den mindestens ein Ligand organischer Natur gebunden ist, der einen organischen Rest vom Typ Y aufweist.

7. Verfahren nach Anspruch 6, **dadurch gekennzeichnet, dass** das Metall und/oder mindestens eine Halbleiterverbindung, die mindestens ein Metall umfasst, ausgewählt ist aus CdSe, CdTe, ZnO, PbSe, PbS, InP, InN, CuInS₂, CuInSe₂, Cu(In,Ga)Se₂, GaAs, InGaAs, Si, Ge, Au, Ag und Pt.

8. Verfahren nach den Ansprüchen 6 und 7, **dadurch gekennzeichnet, dass** der Ligand die Formel (III) aufweist:
BG - (SG)ₚ - Y
wobei:
- BG eine Bindungsgruppe darstellt, die dazu in der Lage ist, an Nanopartikel zu binden;
- SG eine Spacergruppe darstellt;
- p gleich 0 oder 1 ist.

9. Verfahren nach Anspruch 8, **dadurch gekennzeichnet, dass** BG ein Thiol, ein Dithiol, ein Carbodithioat, ein Dithiocarbamat, ein Xanthat, eine Carbonsäure, eine Dicarbonsäure, eine Phosphonsäure, eine Diphosphonsäure, eine Sulfonsäure oder eine Hydroxamsäure ist.

10. Verfahren nach den Ansprüchen 8 und 9, **dadurch gekennzeichnet, dass** der Spacer aliphatischer Natur ist.

11. Verfahren nach einem der vorhergehenden Ansprüche, **dadurch gekennzeichnet, dass** der Träger ausgewählt ist aus Glas, Glimmer, Silicium, das eine Oxidschicht aufweist, und Indiumzinnoxid (ITO).

12. Verfahren nach einem der vorhergehenden Ansprüche, **dadurch gekennzeichnet, dass** die Abscheidungsschritte durch Tränken des Trägers in Lösungen eines konjugierten organischen Polymers, das organische Reste vom Typ X aufweist und eines oder mehrerer organischer Reste vom Typ Y durchgeführt werden.

13. Mehrschichtiger organisch-anorganischer Hybridfilm, umfassend:
- m Schichten konjugiertes organisches Polymer, das organische Reste vom Typ X aufweist;
- n Schichten Nanopartikel, die einen oder mehrere organische Reste vom Typ Y aufweisen;
wobei die Reste vom Typ X und Y dazu in der Lage sind, Bindungen vom Wasserstofftyp untereinander auszubilden
wobei das konjugierte organische Polymer, das organische Reste vom Typ X aufweist, mit der Diaminopyrimidin-Funktion funktionalisiertes Poly(3-hexylthiophen) ist.

14. Träger, beschichtet mit einem mehrschichtigen organisch-anorganischen Hybridfilm nach Anspruch 13.

15. Elektronische Vorrichtung, **dadurch gekennzeichnet, dass** sie umfasst:
- einen teilweise mit einem Film nach den Ansprüchen 13 und 14 beschichteten Träger;
- eine metallische Schicht auf zumindest einem Teil des Films;
- elektrische Kontakte, angeordnet zwischen einem nicht mit Film bedeckten Teil des Trägers, welcher die Anode darstellt, und der metallischen Schicht, welche die Kathode darstellt.

16. Verwendung eines mehrschichtigen organisch-anorganischen Hybridfilms nach Anspruch 13 oder eines mit einem Film beschichteten Trägers nach Anspruch 14 in einer Fotovoltaikzelle.

## Claims

1. Process for the non-covalent coating of a support by a hybrid organic/inorganic film comprising the steps of:
- depositing a conjugated organic polymer comprising organic groups of X type onto the support;
- depositing nanoparticles comprising one or more organic groups of Y type onto the support;
said groups of X and Y types being capable of developing hydrogen-type bonds between themselves, and
the conjugated organic polymer comprising the organic groups of X type being the poly(3-hexylthiophene) functionalized by a diaminopyrimidine function.

2. Process according to claim 1, **characterized in that** the deposition steps are repeated alternately.

3. Process according to claims 1 and 2, wherein X and Y have within them, in the case of X the carbon-containing structure of formula (I): 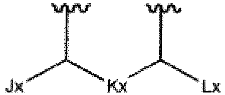 and in the case of Y the carbon-containing structure of formula (II): 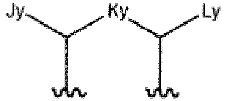 and wherein
- hydrogen bonds are capable of forming in at least two of the pairs Jx/Jy, Kx/Ky, Lx/Ly;
- for the pair Jx/Jy, one of the Jx and Jy represents an N or an O covalently bonded to a hydrogen and the other represents an N or an O π-type bonded with an atom;
- for the pair Kx/Ky, one of the Kx and Ky represents a nitrogen atom covalently bonded to a hydrogen, and the other represents an N π-type bonded with an atom;
- for the pair Lx/Ly, the Lx and Ly independently represent hydrogen or carbon atoms, an N or an O covalently bonded to a hydrogen, or at least one N or one O π-type bonded with an atom.

4. Process according to claim 3, wherein X and Y correspond to pairs of diaminopyrimidine/thymine.

5. Process according to claim 1, wherein the quantity of modified monomeric units which comprises the X group is comprises between 5 and 50%.

6. Process according to one of the previous claims, **characterized in that**, the nanoparticles have an inorganic core constituted by at least one metal and/or at least one semi-conductor compound comprising at least one metal, to which at least one ligand, of organic nature, comprising an organic group of Y type is bonded.

7. Process according to claim 6, **characterized in that** the metal and/or at least one semi-conductor compound comprising at least one metal is chosen from CdSe, CdTe, ZnO, PbSe, PbS, InP, InN, CulnS₂, CulnSe₂, Cu(In,Ga)Se₂, GaAs, InGaAs, Si, Ge, Au, Ag and Pt.

8. Process according to claims 6 and 7, **characterized in that** the ligand is of formula (III) :
BG - (SG)ₚ - Y
in which:
- BG represents a linkage group capable of binding to the nanoparticles;
- SG represents a spacer group;
- p is equal to 0 or 1; and

9. Process according to claim 8, **characterized in that** BG is a thiol, a dithiol, a carbodithioate, a dithiocarbamate, a xanthate, a carboxylic acid, a dicarboxylic acid, a phosphonic acid, a diphosphonic acid, a sulphonic acid or a hydroxamic acid.

10. Process according to claims 8 and 9, wherein the spacer is aliphatic in nature.

11. Process according to one of the previous claims, **characterized in that** the support is chosen from glass, mica, silicon having an oxide layer, and indium tin oxide (ITO).

12. Process according to one of the previous claims, **characterized in that** the deposition steps are carried out by dipping the support in solutions of conjugated organic polymer comprising organic groups of X type and one or more organic groups of Y type.

13. Hybrid organic-inorganic multilayer film comprising:
- m layers of conjugated organic polymer comprising organic groups of X type;
- n layers of nanoparticles comprising one or more organic groups of Y type;
the groups of X and Y types being capable of developing hydrogen-type bonds between themselves, and
the conjugated organic polymer comprising the organic groups of X type being a poly(3-hexylthiophene) functionalized by a diaminopyrimidine function.

14. Support coated with a hybrid organic-inorganic multilayer film according to claim 13.

15. Electronic device, **characterized in that** it comprises:
- a support partly coated with a film according to claims 13 and 14;
- a metallic layer over at least part of the film;
- electrical contacts established between a part of the support not covered by the film, which constitutes the anode, and the metallic layer, which constitutes the a cathode.

16. Use of a hybrid organic-inorganic multilayer film according to claim 13 or a support coated with a film according to claim 14 in a photovoltaic cell.
